(19) Europäisches Patentamt / European Patent Office / Office européen des brevets

(11) **EP 1 904 872 B1**

(12) **FASCICULE DE BREVET EUROPEEN**

(45) Date de publication et mention de la délivrance du brevet:
**22.03.2017 Bulletin 2017/12**

(21) Numéro de dépôt: **06777732.6**

(22) Date de dépôt: **12.07.2006**

(51) Int Cl.:
**G01T 1/17** *(2006.01)*

(86) Numéro de dépôt international:
**PCT/EP2006/064163**

(87) Numéro de publication internationale:
**WO 2007/006801 (18.01.2007 Gazette 2007/03)**

(54) **TRAITEMENT AMÉLIORÉ D'UN SIGNAL REPRÉSENTATIF DE RAYONNEMENT**

VERBESSERTE VERARBEITUNG EINES STRAHLUNG REPRÄSENTIERENDEN SIGNALS

IMPROVED PROCESSING OF A SIGNAL REPRESENTING RADIATION

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **12.07.2005 FR 0507451**

(43) Date de publication de la demande:
**02.04.2008 Bulletin 2008/14**

(73) Titulaire: **Commissariat à l'Énergie Atomique et aux Énergies Alternatives
75015 Paris (FR)**

(72) Inventeurs:
- **EGLIN, Luc**
  **F-75010 Paris (FR)**
- **BARAT, Eric**
  **F-91470 Limours (FR)**

(74) Mandataire: **Regimbeau
20, rue de Chazelles
75847 Paris Cedex 17 (FR)**

(56) Documents cités:
DE-A1- 19 730 679     US-A- 5 684 850
US-A1- 2005 129 152

**Description**

La présente invention concerne un procédé de traitement d'un signal temporel numérique bruité $y_k$ correspondant à un signal initial analogique $s_t$ après avoir été conditionné par une chaîne de conditionnement, ledit signal initial analogique $s_t$ étant représentatif d'une information sur des rayonnements provenant d'une source de rayonnements, ces rayonnements pouvant présenter une distribution en énergie.

Un tel procédé, ou système apte à mettre en oeuvre ce procédé, est généralement utilisé dans le cadre d'une détection, d'un comptage et d'une mesure d'événements, tels la détection desdits rayonnements émis.

Il a notamment pour objet la construction d'un spectre permettant une mesure et une analyse des rayonnements fournis par la source.

On notera que selon l'invention, on considère comme rayonnement, tout rayonnement apte à interagir avec un moyen de détection de sorte à disposer d'un signal temporel exploitable.

A cet égard, et à titre d'exemples non limitatifs, les rayonnements visés par l'invention concernent en particulier des photons, en particulier X et gamma, des particules nucléaires ou plus généralement encore toute particule ou tout paquet de particules.

Ainsi un système ou procédé du type proposé ci-dessus peut notamment avoir pour objet la construction d'un spectre présentant un nombre de particules détectées à une énergie donnée en fonction de l'énergie.

Ceci est notamment intéressant dans le cas de sources de particules présentant une distribution en énergie.

On sait en effet qu'un spectre obtenu à partir d'une telle source peut comporter des raies d'énergie qui lui sont caractéristiques.

Par conséquent, à partir d'une mesure de la source de particules, on peut obtenir un spectre dont un examen par un spécialiste ou par un logiciel permet d'accéder à des informations sur ladite source de particules.

L'examen permet notamment d'identifier la nature de la source étudiée.

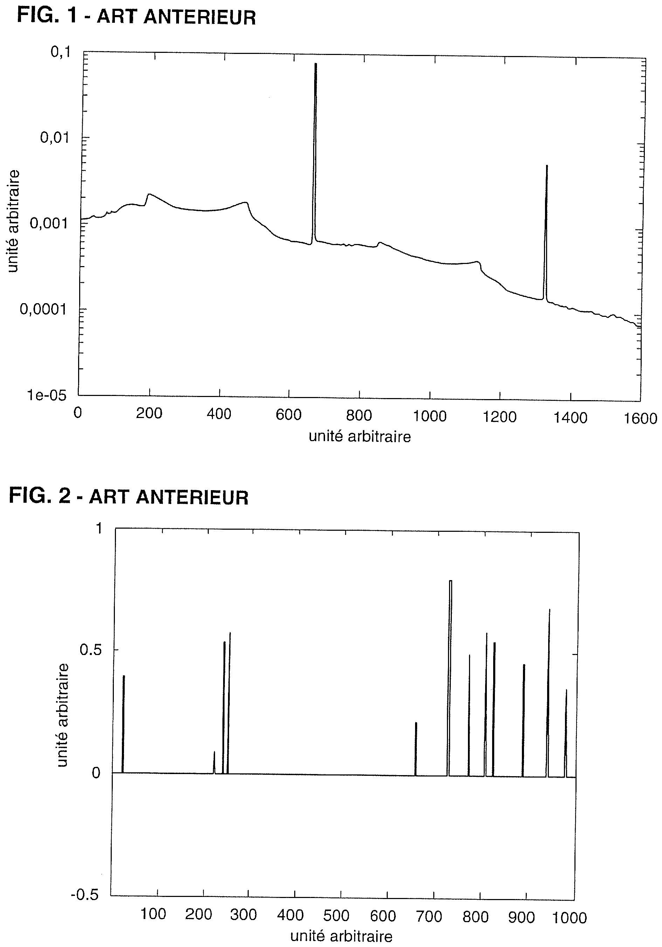

Dans l'exemple non limitatif du domaine des rayons gamma, un système ou procédé du type précité peut fournir un spectre de raies, tel que représenté sur la figure 1, qui permet d'identifier les radioéléments qui composent cette source, et donc de caractériser cette dernière.

On notera que la figure 1 représente à titre d'exemple un spectre en énergie normalisé pour le Césium 137.

Afin d'expliquer maintenant un fonctionnement typique des systèmes de l'état de l'art du type précité, on va s'appuyer sur un exemple dans le domaine de la spectrométrie gamma.

Bien entendu, l'homme du métier pourra sans difficulté étendre cet exemple à d'autres catégories de rayonnements dont ceux, par exemple, énoncés plus haut.

On a représenté sur la figure 2 un signal que l'on pourrait idéalement observer immédiatement en sortie d'un détecteur de photons gamma.

Ce signal comporte une pluralité d'impulsions d'amplitude et de durée différentes qui représentent par exemple un courant généré par le détecteur par le passage d'un photon sur celui-ci.

On notera ici que cette pluralité d'impulsions pourrait aussi représenter une tension générée par le détecteur.

Dans tous les cas, on appellera dans la suite du texte, signal courant détecteur un signal fourni par le détecteur.

Pour revenir brièvement sur les impulsions, leur largeur, correspondant à une certaine durée dans le temps, est fonction d'un temps de collection de charge.

Comme évoqué précédemment, le signal courant détecteur représenté sur la figure 2 est idéal.

Par conséquent, un tel signal n'est jamais observable.

En réalité, on installe généralement un préamplificateur en sortie du détecteur afin de mettre en oeuvre une première mise en forme du signal courant détecteur.

Généralement, deux cas de préamplificateurs sont trouvés dans les systèmes existants : les préamplificateurs à contre-réaction capacitive et les préamplificateurs à contre-réaction résistive.

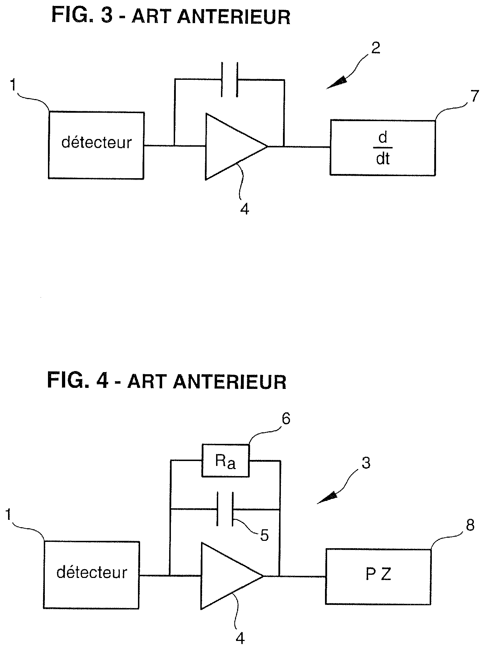

A titre indicatif, les figures 3 et 4 illustrent un détecteur 1 suivi, respectivement, d'un préamplificateur à contre-réaction capacitive 2 et d'un préamplificateur à contre-réaction résistive 3 lequel comporte une boucle de rétroaction entre une sortie et une entrée d'un amplificateur 4 composée d'une capacité 5 en parallèle à une résistance 6.

Ces préamplificateurs sont généralement suivis d'un circuit différentiateur 7 dans le cas d'une contre-réaction capacitive et d'un circuit à correction pole-zéro PZ 8 dans le cas d'une contre-réaction résistive.

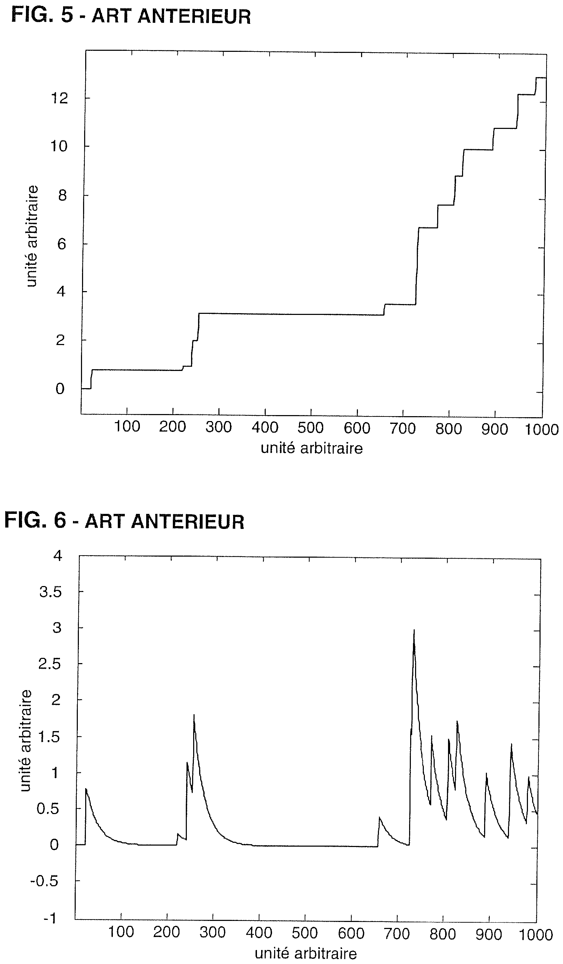

Les deux figures 5 et 6 montrent respectivement un exemple de signal temporel idéal en sortie des deux types de préamplificateurs précités lorsqu'ils sont excités en entrée par un même signal courant détecteur, étant entendu que des bruits de nature électronique ne sont pas représentés ici.

Plusieurs étapes suivent celle de la préamplification.

Leur ordre et leur mise en oeuvre peuvent varier de manière importante.

Une étape connue et importante consiste en une mise en forme des impulsions pour en extraire une information du type énergie.

On désigne couramment une telle étape par étape de « mise en forme énergie ».

A titre d'exemple non limitatif, on peut extraire l'information à partir d'une mesure de l'amplitude ou de l'aire de chaque impulsion.

On suppose en effet que ces grandeurs sont généralement proportionnelles à une énergie.

Le choix du type de « mise en forme énergie » a fait l'objet d'une recherche considérable ces dernières années dans le domaine de l'invention, car cette étape délicate nécessite de nombreux compromis.

Par exemple, dans le cas d'une extraction de l'information à partir de l'amplitude des impulsions, un compromis veut qu'il existe un optimum entre :

- une obtention très précise de cette information, c'est-à-dire une grande résolution,
- le nombre d'impulsions par unité de temps présent dans le signal courant détecteur, et
- la fraction d'entre elles que l'on souhaite conserver dans le spectre, du fait par exemple d'un phénomène connu en soi que l'on nomme couramment dans le domaine par le terme « empilement » d'impulsions.

Pour plus de détails, le lecteur pourra se référer notamment aux notions de taux d'entrée spectre ou OCR (acronyme de « Output Count Rate » en langue anglo-saxonne), et de taux de sortie détecteur ou ICR (acronyme de « Input Count Rate » en langue anglo-saxonne).

Afin d'obtenir une solution optimale à ce compromis, des travaux [1], [2] ont établi que l'utilisation d'un filtre de forme trapézoïdale pouvait constituer une solution optimum en l'absence d'empilements d'impulsions et pour une certaine nature de bruit.

Depuis, d'autres solutions toujours basées sur l'utilisation de ce type de filtre ont été proposées pour améliorer les performances des systèmes.

Par exemple, de nombreuses possibilités de réalisation de ce type de filtre ont été proposées [1-8]: des réalisations numériques, analogiques, voire mixtes, etc.

On connaît également des solutions dont le but est d'améliorer les performances par un autre moyen : optimisation de ladite correction PZ [6,9,10,11], optimisation d'une opération classique consistant à corriger une ligne de base [12], rejet d'impulsions empilées par corrélation entre la longueur et l'amplitude d'une impulsion non empilée [13], etc.

Mais, ces solutions consistent encore à utiliser un filtre optimal trapézoïdal pour l'étape « mise en forme énergie ».

Ainsi, les procédés et systèmes proposés jusqu'ici comportent dans tous les cas un filtre trapézoïdal et plus généralement une étape de mise en forme énergie.

Bien qu'ayant rendu de nombreux services, les performances de ces systèmes ou procédés sont néanmoins encore limitées.

En particulier, l'utilisation dudit filtre trapézoïdal dégrade encore trop le signal courant détecteur -tout du moins le signal préamplifié-, notamment par un allongement temporel des impulsions.

Par conséquent, lorsque la fréquence d'occurrence d'impulsions augmente (du fait d'une augmentation de la fréquence des événements, par exemple des émissions de particules), les systèmes ou procédés de ce type commencent à dysfonctionner, aboutissant par exemple à des spectres de faible résolution voire déformés.

Cela est typiquement le cas vers 100 000 à 200 000 coups par seconde (taux de comptage).

Et pour les systèmes les plus performants, tout juste peut-on atteindre 300 000 à 400 000 coups par seconde.

Un autre inconvénient des systèmes précités est que leur utilisation demeure peu flexible.

En particulier, il est difficile voire impossible d'adapter ou modifier des paramètres de l'étape de mise en forme énergie au cours d'une analyse de la source de rayonnement.

Il est donc nécessaire en phase initiale de connaître, tout du moins d'estimer le mieux possible, le nombre d'impulsions par seconde pour régler le système à l'avance, et ce particulièrement au niveau de la détection.

Et, si le nombre d'impulsions est surévalué une convolution trop courte sera choisie, ce qui dégradera la résolution.

Tandis que, si ce nombre est sous-évalué une convolution trop longue sera choisie, ce qui conduira à rejeter beaucoup d'impulsions et à distordre le spectre.

A titre d'exemple, les systèmes qui par leur situation ne peuvent être réglés à la mise en service uniquement sont généralement réglés sur un pire cas.

Régler sur un pire cas peut notamment consister à régler le système en fonction de la plus forte intensité d'impulsion mesurée.

Mais, cette intensité variant au cours du temps le réglage optimal pour faire fonctionner le système ne vaut plus.

Un autre inconvénient encore est que les systèmes et procédés précités s'avèrent généralement peu efficaces pour détecter des impulsions de faible énergie (ou amplitude), en particulier lorsqu'elles sont en limite de bruit, voire même noyées dans celui-ci.

Ainsi, les performances de ces systèmes et de ces procédés sont très vite limitées lorsque les rapports signal à bruit sont faibles (SNR pour « Signal to Noise Ratio » en langue anglosaxonne).

Le document US 2005/129152 A1 décrit un procédé de traitement d'un signal temporel numérique bruité yk de pas numérique k, correspondant à un signal initial analogique st après avoir été conditionné par une chaîne de conditionnement, ledit signal initial analogique st comportant au moins une impulsion représentative d'une information sur au moins un rayonnement provenant d'une source de rayonnements, ce rayonnement et cette impulsion présentant une distribution en énergie, dans lequel l'on détermine à partir du signal temporel bruité yk un signal d'estimation numérique non bruité sk au moyen d'un modèle d'état représentatif dudit conditionnement imposé par la chaîne de conditionnement.

Un but de l'invention est donc de proposer un procédé et un système amélioré permettant de pallier au moins aux limitations précitées.

Afin d'atteindre ce but, l'invention propose un procédé de traitement d'un signal temporel numérique bruité yk de pas numérique k, correspondant à un signal initial analogique st après avoir été conditionné par une chaîne de conditionnement, ledit signal initial analogique st comportant au moins une impulsion représentative d'une information sur au moins un rayonnement provenant d'une source de rayonnements, ce rayonnement et cette impulsion présentant une distribution en énergie, caractérisé en que l'on détermine à partir du signal temporel bruité yk un signal d'estimation numérique non bruité sk au moyen d'un modèle d'état représentatif dudit conditionnement imposé par la chaîne de conditionnement et en ce que le modèle d'état comporte une variable markovienne rk à estimer dont au moins deux valeurs sont associées à des caractéristiques physiques d'au moins deux impulsions type, ces impulsions type constituant une représentation possible, tout au moins approchée, de l'impulsion dans le signal st.

Des aspects préférés mais non limitatifs de ce procédé sont les suivants :

- le procédé comporte en outre une étape préalable où l'on segmente le signal temporel numérique bruité yk en tronçons successifs de N échantillons ;
- l'une des valeurs de la variable markovienne correspond à un mode d'impulsion, dit mode « bruit », pour lequel on considère qu'il n'existe pas d'impulsion dans le signal à un pas k donné ;
- le modèle d'état comporte en outre un vecteur F de constantes dépendantes de la variable markovienne et qui définissent en tant que caractéristiques physiques une gamme énergétique liée à l'impulsion type en question ;
- les constantes du vecteur F sont proportionnelles à une amplitude maximale prédéterminée $A_{min}$ d'une impulsion type liée à la gamme énergétique la plus faible, le mode « bruit » n'étant pas considéré ici ;
- le modèle d'état comporte un vecteur d'état $X_k$ à estimer, lequel comporte une première composante qui correspond à l'estimation numérique non bruitée $s_k$, c'est à dire à la représentation numérisée du signal initial temporel $s_t$ à l'instant t correspondant au pas k en question, et la détermination à partir du signal temporel bruité $y_k$ du signal d'estimation numérique non bruité $s_k$ au moyen du modèle d'état comporte une étape intermédiaire de mise en oeuvre d'un filtre de Kalman d'observation le signal temporel numérique bruité $y_k$, cette étape intermédiaire fournissant une estimation intermédiaire $X_{k/k}$ du vecteur d'état $X_k$ comportant ainsi un signal d'estimation numérique intermédiaire $s_{k/k}$ non bruité, celui-ci correspondant à une première détermination du signal d'estimation numérique non bruité $s_k$ que l'on cherche à obtenir ;
- la détermination à partir du signal temporel bruité $y_k$ du signal d'estimation numérique non bruité $s_k$ au moyen du modèle d'état comporte une seconde étape intermédiaire de mise en oeuvre d'un algorithme de lissage, cette étape intermédiaire fournissant une estimation lissée $X_{k/N}$ améliorée du vecteur d'état $X_k$, et donc une estimation lissée $s_{k/N}$ améliorée du signal d'estimation numérique non bruité $s_k$ que l'on cherche à obtenir ;
- la variable cachée $r_k$ est estimée au moyen d'un algorithme de Viterbi ;
- on utilise un critère d'optimisation du Maximum A Posteriori (MAP) ;
- le critère du Maximum A Posteriori (MAP) est combiné à un algorithme Expectation-Maximization (EM) ;
- le critère du Maximum A Posteriori combiné à l'algorithme Expectation-Maximization (EM) est mis en oeuvre au choix :

  - pour l'estimation de la variable cachée $r_k$,
  - pour l'estimation du vecteur d'état $X_k$, ou
  - pour l'estimation de la variable cachée $r_k$ et du vecteur d'état $X_k$ ;

- le modèle d'état s'exprime sous la forme suivante :

$$\begin{cases} X_{k+1} & = & A(r_{k+1})X_k & + & G(r_{k+1}) & + & B(r_{k+1})v_{k+1} \\ y_k & = & CX_k \end{cases}$$

avec :

$$X_k = \begin{pmatrix} s_k \\ b_k \\ n_k \end{pmatrix},$$

où A est une matrice d'état, C une matrice d'observation, $v_k$ un vecteur de bruit blanc gaussien de variance unité, G un vecteur comportant le vecteur F de constantes, B une matrice de bruit dynamique, $b_k$ un biais, et $n_k$ un bruit intrinsèque à un détecteur des rayonnements utilisé dans la chaîne de conditionnement ;

- le procédé comporte une étape d'initialisation dans laquelle la matrice de bruit dynamique B associée au canal énergétique le plus faible est égale à celle associée au canal énergétique juste supérieur, soit

$$B(r_k=0) = B(r_k=1)$$

et dans laquelle, pour les valeurs de $r_k$ supérieures ou égales à 1, la matrice $B(r_k)$ est déterminée par

$$B(r_k) = F(r_k) - F(r_{k-1}), \ r_k \geq 1$$

On propose également un programme d'ordinateur pour le traitement d'un signal temporel numérique bruité $y_k$ de pas numérique k, correspondant à un signal initial analogique $s_t$ après avoir été conditionné par une chaîne de conditionnement, ledit signal initial analogique $s_t$ comportant au moins une impulsion représentative d'une information sur au moins un rayonnement provenant d'une source de rayonnements, ce rayonnement et cette impulsion présentant une distribution en énergie, caractérisé en qu'il comporte des instructions pour la mise en oeuvre du procédé selon l'une quelconque des revendications précédentes.

On propose en outre un système de traitement d'un signal temporel numérique bruité yk de pas k correspondant à un signal initial analogique st après avoir été conditionné par une chaîne de conditionnement, ledit signal analogique st comportant au moins une impulsion représentative d'une information sur des rayonnements provenant d'une source de rayonnements, ces rayonnements et cette impulsion présentant une distribution en énergie, caractérisé en qu'il comporte des moyens coopérant avec un modèle d'un état représentatif dudit conditionnement imposé par la chaîne de conditionnement pour déterminer à partir du signal temporel bruité yk un signal d'estimation numérique non bruité sk et en ce que le modèle d'état comporte une variable markovienne rk à estimer dont au moins deux valeurs permettent de définir des caractéristiques physiques d'au moins deux impulsions type, ces impulsions type constituant une représentation possible, tout au moins approchée, de l'impulsion dans le signal st.

On propose également un spectromètre, et un bolomètre comportant des moyens aptes à mettre en oeuvre le procédé précité.

Ainsi, grâce au procédé de l'invention on s'affranchit avantageusement de l'étape de mise en forme qui limitait jusque là les procédés et systèmes de l'art antérieur.

En effet, cette étape est avantageusement remplacée par l'établissement d'un modèle d'état incluant des paramètres à estimer et qui permet d'obtenir une représentation numérique fidèle du courant détecteur aussi bien lorsque l'énergie des impulsions dans ce signal est très supérieure au niveau de bruit que lorsqu'elle est de l'ordre de ce niveau de bruit.

En outre ces performances peuvent être obtenues tout en utilisant des taux de comptage très élevés au regard de l'état de la technique.

D'autres aspects, buts et avantages de l'invention apparaîtront mieux à la lecture de la description suivante d'un mode de réalisation de l'invention, faite en référence aux dessins annexés sur lesquels :

- la figure 1, présentée dans le texte ci-dessus, illustre un spectre en énergie d'une source de Césium 137, les unités des axes étant arbitraires,
- la figure 2, présentée dans un exemple ci-dessus, illustre un signal courant détecteur idéal généré par un détecteur de rayon gamma, les unités des axes étant arbitraires,
- la figure 3 représente schématiquement un premier exemple d'une partie d'une chaîne de conditionnement connue, comprenant en aval d'un détecteur : un préamplificateur à contre-réaction capacitive suivi d'un circuit différentiateur,

■ la figure 4 représente schématiquement un deuxième exemple d'une partie d'une chaîne de conditionnement connue, comprenant en aval d'un détecteur : un préamplificateur à contre-réaction résistive suivi d'un circuit à correction pôle-zéro;

■ la figure 5 montre à titre non limitatif un signal issu de la chaîne de conditionnement du premier exemple, cette chaîne comprenant en plus un convertisseur analogique-numérique, les unités des axes étant arbitraires,

■ la figure 6, montre à titre non limitatif un signal issu de la chaîne du deuxième exemple, cette chaîne comprenant en plus un convertisseur analogique-numérique, les unités des axes étant arbitraires,

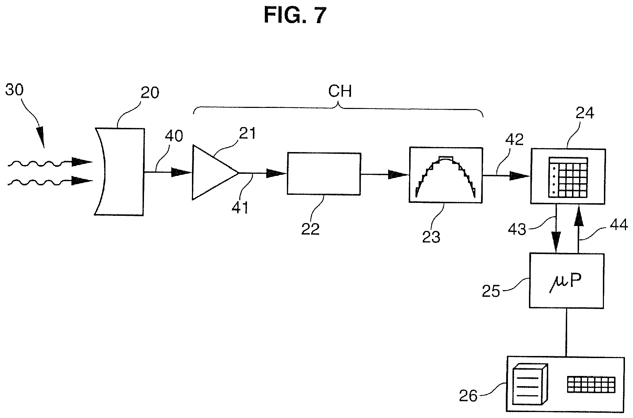

■ la figure 7, montre schématiquement un système complet permettant de mettre en oeuvre le procédé de l'invention,

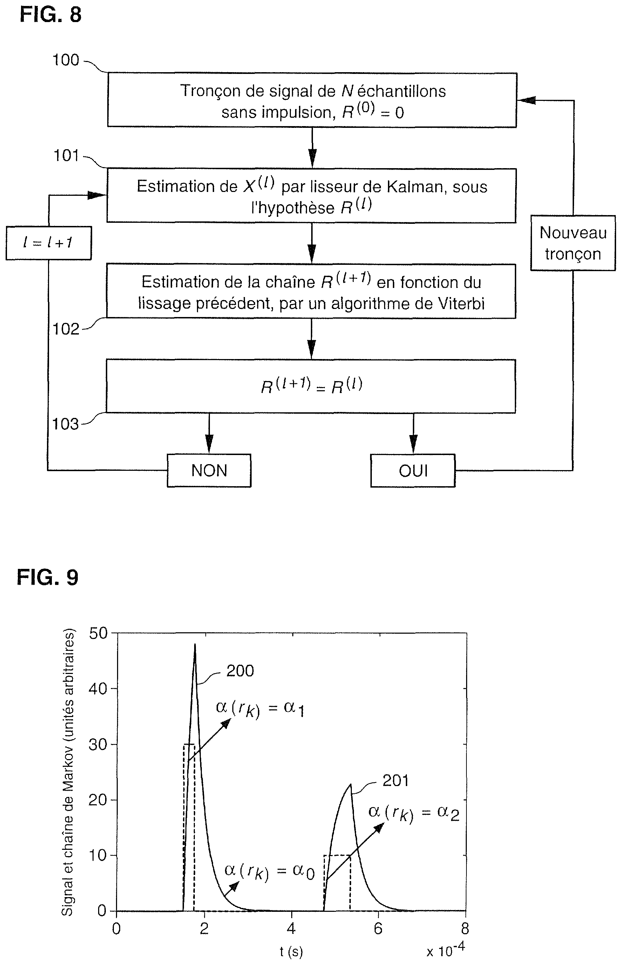

■ la figure 8 montre schématiquement un procédé d'estimation du signal numérique non bruité $s_k$,

■ la figure 9 illustre, dans le cadre d'un exemple d'un mode de réalisation de l'invention, l'utilisation de trois formes temporelles différentes pour modéliser trois impulsions type.

En se référant maintenant à la figure 1, on a représenté schématiquement un mode de réalisation du système de l'invention.

Un tel système comporte essentiellement un détecteur 20 pour détecter des rayonnements 30 provenant d'une source de rayonnement.

Ce détecteur est apte à fournir un signal courant détecteur 40 qui va être conditionné par une chaîne de conditionnement CH représentée sur la figure 7.

Cette chaîne de conditionnement comporte à titre d'exemple non limitatif un préamplificateur du type précité, c'est-à-dire du type à contre-réaction résistive ou à contre-réaction capacitive.

Dans la chaîne de conditionnement CH, le signal préamplifié 41 ainsi obtenu est ensuite présenté à un bloc 22 comportant un circuit de correction pôle-zéro PZ ou un circuit de différentiation selon le choix porté sur le type du préamplificateur 21.

La chaîne de conditionnement CH se termine par un convertisseur analogique-numérique 23 en sortie du bloc 22.

On notera ici que la chaîne de conditionnement CH telle qu'elle est présentée sur la figure peut comporter de nombreuses variantes que l'homme du métier envisagera naturellement.

En particulier, on n'est nullement contraint de respecter un tel agencement des blocs.

Par exemple, on peut envisager que le convertisseur analogique-numérique soit placé plus en amont du système et que la chaîne de conditionnement CH se termine par le bloc 21 (préamplification numérique) puis 22.

Par ailleurs le bloc 22 peut mettre en oeuvre des étapes supplémentaires de conditionnement du signal.

Nous verrons à cet égard dans un exemple détaillé d'un mode de réalisation de l'invention que le bloc 22 peut notamment comporter des circuits électroniques, tel un amplificateur et/ou un filtre anti-repliement.

L'homme du métier comprendra donc sans difficulté qu'il s'agît simplement ici de faire des compromis différents et de choisir une chaîne de conditionnement la plus adaptée à l'application visée.

A l'issue de cette chaîne CH, le signal numérisé 42 est mémorisé dans une mémoire dédiée 24, puis une unité de calcul 25, tel un microprocesseur ou un DSP par exemple (DSP étant l'acronyme « Digital Signal Processing » en langue anglo-saxonne), met en oeuvre des calculs à partir des échantillons du signal mémorisé 43.

C'est en particulier l'unité 25 qui met en oeuvre l'ensemble des étapes permettant d'obtenir une estimée du signal numérique non bruité du signal temporel courant détecteur 40 (dans la suite du texte on désignera ce signal temporel courant détecteur par $s_t$) et ultérieurement un histogramme en énergie de la source de rayonnement étudiée.

On notera que les signaux correspondant notamment aux énergies des rayonnements 44 calculées par l'unité 25 sont stockés dans la mémoire 24 (ils peuvent aussi être stockés dans une mémoire distincte).

Comme on peut également le voir sur ladite figure 7, cette unité 25 gère des périphériques 26 comme un écran d'affichage, un clavier, une souris, etc.

On va maintenant décrire un mode de réalisation préféré du procédé de l'invention correspondant à un traitement du signal numérisé 42 et mis en oeuvre notamment par l'unité de calcul 25.

A titre préliminaire, il est entendu que le variable k représente un pas d'échantillonnage.

En d'autres termes, k désigne un numéro d'échantillon et une correspondance avec la notion d'instant d'échantillonnage peut être effectuée en utilisant la relation classique :

$$t = k \, / \, fe,$$

où t est l'instant d'échantillonnage et fe la fréquence d'échantillonnage du convertisseur 23.

On notera également qu'un indice k/k d'une variable désignera une estimation de cette variable obtenue par exemple à partir d'un filtre de Kalman ; un indice k/N désignera une estimation obtenue à partir d'un algorithme de lissage; un indice k+1/k désignera une prédiction de la variable indicée comme tel ; $s_k$ désignera une représentation numérique que l'on cherche à estimer du signal $s_t$.

L'unité de calcul 25 procède tout d'abord à une segmentation du signal 42 qui a été préalablement mémorisé dans la mémoire 24.

Une telle segmentation est agencée de sorte à obtenir des tronçons successifs de N échantillons.

L'unité de calcul 25 déduit ensuite par mise en oeuvre de calculs classiques un signal numérique temporel bruité $y_k$ représentant une version numérique du signal 41, et ce à partir du signal 42.

Le signal numérique temporel bruité $y_k$ est alors utilisé pour l'établissement d'un modèle d'état dont une forme de développement va être maintenant décrite dans le cadre d'une application bolométrique donnée à titre d'exemple non limitatif.

A titre préliminaire, on va d'abord décrire un principe important sur lequel repose le modèle d'état selon l'invention.

### Utilisation d'une chaîne de Markov

On sait que lorsqu'une impulsion est générée dans le signal courant détecteur du fait d'un rayonnement, elle peut de façon typique posséder un temps de montée court et un temps de descente de forme exponentielle.

On sait en outre que ces deux grandeurs ainsi que l'amplitude de l'impulsion dépendent du type de rayonnement.

Selon l'invention, on peut aider à la représentation de ces différents types de rayonnement, et par analogie type d'impulsion, en utilisant dans le modèle d'état une chaîne de Markov R:

$$R = \{r_k\}, k = 1\ldots N$$

où N est le nombre d'échantillons d'un tronçon précité et $r_k$ une variable Markovienne.

A chaque valeur de $r_k$ correspond une impulsion type dont on définit a priori des caractéristiques permettant de la représenter (temps de montée et de descente, amplitude ...).

On considèrera par la suite qu'une valeur de $r_k$ définit un mode d'impulsion, c'est-à-dire des caractéristiques prédéterminées d'impulsion.

A priori, une quelconque impulsion présente dans le signal courant détecteur peut toujours être associée à un des modes d'impulsion prédéfinis.

Le mode d'impulsion associé à ladite impulsion est celui auquel correspond dans un premier temps les caractéristiques qui permettent une représentation la plus proche de l'impulsion en question.

Il n'est donc pas nécessaire que les caractéristiques physiques réelles de impulsion en question soient exactement celles définies dans l'un quelconque des différents modes d'impulsion.

On notera que, selon l'invention un mode d'impulsion peut aussi définir des caractéristiques de bruit seules.

Un tel mode d'impulsion correspond en particulier au cas ou le signal ne comporte pas d'impulsion à un pas k mais uniquement du bruit.

A cet égard, on définira un premier mode d'impulsion $r_k=0$, dit mode « bruit », pour lequel le signal courant détecteur ne présente pas d'impulsion au pas k considéré (le signal ne contient donc que du bruit).

On définira en outre, un deuxième mode d'impulsion $r_k=1$, pour lequel le signal comporte une impulsion présentant des caractéristiques physiques proches d'une certaine amplitude A, d'un temps de monté $t_1$, etc.

Bien que ces deux modes d'impulsion puissent suffire, on pourra bien entendu en définir d'autres.

Une équation du signal d'estimation non bruité $s_k$ du signal courant détecteur peut s'exprimer de manière simplifiée sous la forme suivante :

$$s_k = \alpha(r_k)s_{k-1} + F(r_k) \qquad (1)$$

où $\alpha(r_k)$ est un vecteur comportant des constantes de temps de montée et de descente.

Dans l'exemple de la bolométrie, on peut fixer les valeurs de $\alpha(r_k)$ à partir de grandeurs thermodynamiques, comme une capacité calorifique du détecteur et une conductivité thermique entre un absorbeur et un senseur de ce détecteur.

Typiquement pour le mode « bruit » ($r_k=0$) on peut définir :

$$\alpha(r_k = 0) = \exp(-1/\tau d)$$

avec,

$$\tau d = C/G,$$

et pour les autres modes,

$$\alpha( r_k = 1) = \exp(-1/\tau d1)$$

avec,

$$\tau d1 = C1/G1, \text{ etc…}$$

Ainsi, la valeur de la variable Markovienne qui correspond à un mode d'impulsion donné, détermine ici la valeur de la constante de temps à prendre en compte pour aider à l'estimation de l'impulsion en cours d'analyse au pas k.

Comme on peut le voir, F est aussi un vecteur fonction de la variable markovienne $r_k$.

Plus précisément, F représente dans le cas d'espèce un pas de montée de l'impulsion au pas k.

En particulier, si l'impulsion présente un front de montée sous forme de droite, F représente la pente de cette dernière.

Ainsi, à une valeur nulle de F correspond une pente nulle, tout du moins sensiblement nulle, traduisant ainsi une absence d'impulsion.

La forme du signal est donc censée ne pas varier (ou peu varier) si au pas précédent il ne comportait déjà que du bruit, ou bien le signal est censé retourner à l'équilibre sous forme d'exponentielle décroissante si au pas précédent il comportait une impulsion.

Comme on l'aura compris un tel événement correspond typiquement au mode « bruit » précité.

Et l'équation (1) peut dès lors être exprimée sous la forme :

$$s_k = \alpha(r_k = 0)\, s_{k-1} + F(r_k=0),$$

$$\text{soit, } s_k = \alpha(r_k = 0)\, s_{k-1}$$

On peut remarquer que, dans l'exemple considéré ici à titre non limitatif, la variable markovienne $r_k$ permet une sélection sur les caractéristiques de temps de montée, de descente et d'amplitude d'une impulsion donnée afin d'aider à l'estimation de sa représentation $s_k$.

Faire dépendre la valeur F de la variable aléatoire $r_k$ permet de prendre en compte à travers la notion d'amplitude n'importe quel type d'énergie pour une impulsion, y compris celles en limite de bruit.

De plus, on améliore l'estimation de cette énergie du fait d'un modèle d'état très affiné pour différentes gammes d'énergies possibles (ou par analogie pour différentes gammes d'amplitudes).

Par ailleurs, faire dépendre la valeur $\alpha$ de la chaîne aléatoire $r_k$ permet de prendre en compte différentes formes de signaux.

On peut ainsi classifier des impulsions issues d'événements de nature différentes.

**Proposition d'un modèle d'état incluant une chaîne de Markov**

Ayant présenté ci-dessus des avantages liés au principe d'utiliser une variable markovienne pour modéliser le signal courant détecteur comportant des impulsions à estimer, nous décrivons maintenant un mode de réalisation préféré de l'invention implémentant un tel principe.

Un modèle d'état que propose l'invention est donné sous forme d'équation ci-dessous :

$$\begin{cases} X_{k+1} &=& A(r_{k+1})X_k &+& G(r_{k+1}) &+& B(r_{k+1})v_{k+1} \\ y_k &=& CX_k \end{cases}$$

avec,

$$X_k = \begin{pmatrix} s_k \\ b_k \\ n_k \end{pmatrix}$$

où A est une matrice d'état comportant $\alpha$ et d'autres coefficients modélisant notamment le bruit et la fonction de transfert du préamplificateur, C une matrice d'observation, $v_k$ un bruit blanc gaussien de variance unité, G un vecteur comportant le vecteur F, B une matrice de bruit dynamique, $X_k$ un vecteur d'état comportant le signal numérique non bruité $s_k$ à estimer, $b_k$ un biais , $n_k$ un bruit intrinsèque au détecteur, et $y_k$ le signal numérique bruité utilisé ici comme observation du modèle d'état.

La matrice A combinée à la variable markovienne $r_k$ permet notamment une prise en compte d'une forme temporelle des impulsions selon un mode d'impulsion donné (exponentiel, etc...).

Et F et B combinés à ladite variable $r_k$ permettent une prise en compte d'une gamme énergétique d'impulsion selon le mode d'impulsion considéré (énergie ou par équivalent amplitude).

Le nombre de gammes énergétiques dépend notamment du nombre de modes d'impulsions choisi, c'est-à-dire du nombre de valeurs prédéterminées que peut prendre la variable markovienne.

On choisira ce nombre selon le cas d'espèce.

Et on notera de manière générale que plus ce nombre augmente et plus la modélisation est précise.

En particulier, une amélioration des performances obtenues avec ce modèle est importante notamment lorsque le signal comporte des impulsions dont l'énergie se trouve en limite de bruit (dit autrement, pour un faible rapport signal à bruit) et qu'il devient donc difficile de détecter.

A cet égard, on pourra s'arranger d'un côté pour qu'un plus grand nombre de modes d'impulsion soit défini pour les impulsions d'énergie faible.

On notera d'un autre côté que, plus le nombre de modes d'impulsion augmente et plus la dimension du modèle d'état augmente, ce qui peut ralentir des temps de calcul.

**Estimation des variables du modèle d'état**

Afin d'estimer les variables d'état du modèle d'état, dont en particulier la variable markovienne $r_k$ et le vecteur $X_k$, on utilise un algorithme d'estimation.

Selon un aspect préféré de l'invention, on optimise cet algorithme suivant un critère du Maximum A Posteriori (MAP).

Un avantage d'un tel critère est qu'il prend en compte les observations yk.

On notera en outre qu'un autre avantage de ce critère est qu'il permet d'utiliser un a priori sur la variable à estimer.

Il permet donc une très bonne optimisation des paramètres du modèle d'état.

Selon l'invention, on propose d'appliquer ledit critère MAP précité selon trois possibilités.

On propose de l'appliquer à la chaîne de Markov R uniquement, au vecteur d'état $X_k$ uniquement, ou encore au vecteur d'état $X_k$ et à la chaîne de Markov R conjointement.

En d'autres termes, sous une forme mathématique généralisée on propose :

$$\left\{ \begin{array}{l} \hat{R}^{MAP} = \underset{R}{\arg\max}\, f(R/Y) \quad \text{avec } R = \{r_1,...,r_N\} \text{ et } Y = \{y_1,...,y_N\} \\[2mm] \text{ou} \ \ \hat{X}^{MAP} = \underset{X}{\arg\max}\, f(X/Y) \quad \text{avec } X = \{X_1,...,X_N\} \\[2mm] \text{ou} \ \ (\hat{R},\hat{X}^{MAP}) = \underset{(R,X)}{\arg\max}\, f(X,R/Y) \end{array} \right.$$

où f($\phi$) | Y) désigne une densité de probabilité a posteriori de de $\phi$, c'est-à-dire une probabilité d'avoir $\phi$ étant donné l'observation Y, sachant que $\phi$ correspond selon le choix à R, X ou les deux conjointement.

D'autres critères d'optimisation, comme le critère de Maximum de Vraisemblance, peuvent être utilisés au lieu et place du critère MAP ou en combinaison avec celui-ci.

Pour optimiser f ($\phi$ | Y), on utilise une méthode déterministe offrant notamment comme avantage d'être rapide en temps de mise en oeuvre par rapport à une méthode classique telle que Monte Carlo par Chaîne de Markov (MCMC).

A cet effet on met en oeuvre un algorithme Expectation-Maximization (EM). Le lecteur pourra se référer aux très nombreuses publications concernant cette technique algorithmique connue.

On notera ici qu'un tel algorithme permet lui aussi avantageusement d'utiliser une notion d'a priori sur la chaîne de Markov, sous la forme d'une probabilité de transition de l'instant $k$-1 à $k$.

Ainsi, par l'intermédiaire de cette probabilité on peut avoir dans une certaine mesure un a priori sur une durée des différents modes dans lequel se trouve le système d'état.

Par exemple, on peut avoir un a priori sur une durée moyenne durant laquelle il n'y aurait pas de détection (mode $r_k$=0).

On peut en outre avoir un a priori sur une durée de la montée d'une impulsion.

On a illustré à la figure 8 un schéma d'un mode de réalisation du procédé de l'invention appliqué au cas $\phi$ = R.

L'homme du métier adaptera sans difficulté ce schéma aux deux autres cas proposés plus haut, à savoir les cas où $\phi$ = R et $\phi$ = (R,X).

Comme on peut le voir d'après ladite figure, le procédé est itératif et est basé sur une estimation de la chaîne de Markov R d'une part et du vecteur d'état $X_k$ d'autre part.

Une première étape 100 d'initialisation est mise en oeuvre.

Elle correspond à une valeur nulle de pas d'incrémentation $l$ d'une boucle que l'on va décrire plus loin.

Dans cette phase d'initialisation, sur la base d'un tronçon de N échantillons, on part de l'hypothèse qu'il n'y a pas d'impulsion dans le signal courant détecteur, donc dans le signal d'estimation non bruité $s_k$.

Par conséquent, la chaîne de Markov R est nulle au départ sur tout le tronçon de signal : on se trouve dans le mode « bruit » à chaque pas k.

D'autres paramètres du modèle d'état sont réglés à l'initialisation.

Nous aborderons ceci en de plus amples détails dans une partie ultérieure de la description.

On notera pour l'instant, qu'une fois cette phase d'initialisation terminée, le procédé d'estimation est apte à mettre en oeuvre les prochaines étapes sans pour autant devoir effectuer de nouveaux réglages.

L'une de ces prochaines étapes est désignée par la référence 101.

Elle constitue le début de la boucle itérative sur l'indice 1.

Dans cette étape 101, on met en oeuvre une estimation du vecteur d'état $X_k$ à l'itération 1, compte tenu de la chaîne de Markov R à cette itération.

L'estimation est mise en oeuvre au moyen d'un filtre de Kalman puis au moyen d'un algorithme de lissage, l'ensemble étant appliqué sur le même tronçon N.

L'étape 101 est suivie d'une étape 102 dans laquelle on estime la chaîne de Markov pour l'itération suivante ($l$+1) en fonction du résultat obtenu pour le vecteur d'état $X_k$ à l'itération $l$.

A cet effet, on propose d'utiliser avantageusement un algorithme de Viterbi.

Nous décrirons plus en détails une manière d'implémenter les étapes 101 et 102 dans un exemple donné à titre d'illustration.

Dans une étape 103 qui suit l'étape 102, on effectue un test pour déterminer si les chaînes de Markov aux itérations $l$ et $l$+1 sont identiques.

Si le test est négatif, le pas de la boucle est incrémenté et le procédé repart à l'étape 101.

Inversement, si les chaînes sont identiques, on considère que l'ensemble des variables d'état est optimisé sur le tronçon N considéré et qu'ainsi le signal d'estimation non bruité $s_k$ est une représentation satisfaisante du signal courant détecteur sur ledit tronçon.

Le procédé est alors appliqué à un nouveau tronçon N, typiquement le tronçon N suivant, et recommence à l'étape 100.

**Phase d'initialisation**

**a- Biais $b_k$**

L'étape 100 de la figure 8 peut comporter, en plus des opérations évoquées, une estimation du biais $b_k$ (on rappelle que $b_k$ est intégré dans le vecteur d'état $X_k$).

Ce biais correspond à un niveau de ligne de base du signal numérique bruité $y_k$.

Une telle estimation du biais permet que le filtre de Kalman à l'étape 101 débute dans des conditions optimisées.

A cet effet, le biais $b_k$ est déterminé à partir de l'équation suivante :

$$b_k = b_{k-1} + \sigma_b u_k \qquad (2)$$

où $u_k$ est un bruit blanc gaussien de variance unité et $\sigma_b$ l'écart type associé.

Cet écart type $\sigma_b$ est déterminé en prenant le mode d'un histogramme des valeurs prises par les K premiers échantillons de la donnée correspondant au signal numérique bruité $y_k$.

b- Choix des gammes énergétiques pour F

On considère en premier lieu le mode d'impulsion correspondant à une gamme énergétique la plus faible, mode « bruit » exclu.

Ce mode d'impulsion correspond à $r_k=1$ et est dit le moins énergétique.

Pour ce mode, on détermine une valeur maximale de l'énergie de l'impulsion à détecter.

On déduit ensuite une valeur maximale $F_{max}$ à prendre en compte dans le modèle d'état.

Supposons que l'on cherche à estimer des impulsions en limite de bruit, par exemple des impulsions d'amplitude $A_{min}$ de l'ordre de $3\sigma_n$, avec $\sigma_n$ l'écart type du bruit $n_k$ (l'amplitude $A_{min}$ correspond à l'amplitude maximale en fin d'impulsion, c'est-à-dire l'amplitude au dernier pas k de l'impulsion en question).

On calcule une valeur F1 de F (F1 est associée au mode $r_k=1$) en divisant ladite amplitude $A_{min}$ par le nombre moyen de pas k occupés par l'impulsion, en particulier par son temps de montée.

On notera que le nombre de pas k peut être obtenu par le rapport $T_1/T_e$ si $T_1$ est la durée du mode $r_k=1$, et $T_e$ le pas d'échantillonnage.

En conséquence,

$$F_1 = \frac{T_e}{T_1} A_{min}$$

On obtient ainsi une caractéristique du mode d'impulsion le moins énergétique, i.e. le mode $r_k=1$.

Une procédure sensiblement similaire est mise en oeuvre pour fixer les caractéristiques des autres modes d'impulsion.

On fixe donc l'ensemble des paramètres $F_k$ du vecteur F étant donné le mode $r_k$ considéré.

Selon un aspect de l'invention, on s'arrangera pour que ces autres valeurs de F soient espacées régulièrement.

Selon un autre aspect, on s'arrangera au contraire pour que ces valeurs soient de plus en plus espacées, notamment lorsqu'il est souhaité une précision plus grande à des énergies faibles (ou amplitudes faibles).

A titre d'exemple, on peut fixer:

$F_2 = 2F_1$, $F_3 = 4F_1$, $F_4 = 8F_1$, $F_5 = 16F_1$, etc.... jusqu'à $F_{Nm}$ où $N_m$ est le nombre de modes d'impulsion.

c- Paramètres de bruit

Les bruits pris en compte dans le modèle d'état ont différentes origines.

Il peut s'agir d'un bruit lié au biais précité, d'un bruit associé à une impulsion ou encore d'un bruit intrinsèque au détecteur, à savoir un bruit noté $n_k$., qui existe malgré une absence d'impulsion.

*Bruit $n_k$*

Concernant le bruit intrinsèque au détecteur $n_k$, il est estimé sur des plages de données du signal numérique bruité $y_k$ ne présentant aucune impulsion.

Pour pouvoir intégrer ce bruit dans le modèle d'état, on peut utiliser un modèle ARMA (acronyme de l'expression « AutoRegressive - Moving Average » en langue anglo-saxonne pour « Auto-Régressif à Moyenne Ajustée ».

Soit,

$$n_k = \sum_{\ell=1}^{p} a_\ell n_{k-\ell} + \sum_{m=0}^{q} b_m \varepsilon_{m-k} \qquad (3)$$

où p est l'ordre de la partie auto-regressive (AR) du modèle, q de la partie moyenne mobile (MA), et $\varepsilon_k$ un bruit blanc.

Pour déterminer les coefficients $a_l$, $b_m$ et l'écart type de $\varepsilon_k$, on peut utiliser de façon connue un algorithme des Innovations.

Par exemple si le bruit $n_k$ est déterminé par un modèle AR(1), on a :

$$n_k = a_\ell n_{k-\ell} + \varepsilon_k$$

Pour ce qui concerne le bruit associé à une impulsion, on a pu voir que selon le mode préféré de l'invention il est rendu dépendant de la variable markovienne $r_k$ au moyen de la matrice B.

*Bruit associé à une impulsion : matrice dynamique B*

Les valeurs de B sont déterminées en fonction des valeurs prédéfinies du vecteur $F(r_k)$.

Une grande précision sur les valeurs de F n'est pas nécessaire.

On doit néanmoins s'assurer que les distributions entre deux modes d'impulsion successifs ont une zone d'intersection suffisante.

A cet effet, en ce qui concerne les modes d'impulsion autres que le mode « bruit », on peut par exemple déterminer B de la manière suivante :

$$B(r_k) = F(r_k) - F(r_{k-1}) \text{ pour } r_k \geq 1$$

Pour ce qui concerne le mode « bruit » spécifiquement, on pourrait fixer :

$$B(r_k = 0) = 0$$

Mais la demanderesse a remarqué que B devrait de préférence comporter des petites valeurs non nulles.

Par exemple,

$$B(r_k = 0) = \varepsilon = 1e - 6$$

Ceci permet notamment d'éviter des problèmes de singularité de calcul dans les équations tout en influençant peu le contenu du modèle d'état.

Bien entendu, d'autres valeurs peuvent être choisies pour $\varepsilon$.

La demanderesse a en outre remarqué que, durant la phase d'initialisation, fixer B à $\varepsilon$ pouvait conduire à un absence de mise à jour de la chaîne de Markov au cours des itérations 1 strictement supérieures à 0 (1 >0).

Ainsi il est proposé que durant l'étape 100, pour laquelle $r_k$=0, $B(r_k)$ soit différent de $\varepsilon$.

Selon un aspect préféré de l'invention, il est proposé que, dans la phase d'initialisation 100, B soit déterminé par l'équation suivante :

$$B^{(\ell=0)}(r_k = 0) = B(r_k = 1) = B_1$$

et dans l'itération suivante par :

$$B^{(\ell>0)}(r_k = 0) = \varepsilon$$

d- Choix des formes temporelles des impulsions selon le mode d'impulsion

Une analyse sur des signaux courant détecteur présentant un rapport signal à bruit suffisant permet de modéliser leur forme.

Cette modélisation peut être mise en oeuvre au moyen d'une somme d'exponentielles décroissantes.

Par exemple, on peut utiliser l'équation suivante :

$$s_t = \sum_i \alpha_i \exp(-\beta_i t)$$

où $s_t$ est le signal analogique.

Les impulsions observées dans ces signaux peuvent être ajustées à une somme d'exponentielles par un algorithme Nelder-Mead.

De cette manière on simplifie le passage ultérieur à une écriture récursive.

Dans ce type d'écriture récursive, une exponentielle simple peut s'écrire notamment sous la forme suivante:

$$\mathbf{x}_k = \alpha \mathbf{x}_{k-1}$$

Une montée du signal correspondant à une impulsion peut s'écrire aussi grâce à une exponentielle :

$$\mathbf{x}_k = \alpha \mathbf{x}_{k-1} + F$$

**A priori sur la chaîne de Markov**

On a besoin d'estimer les probabilités de transition d'un type d'impulsion à une autre ou de bruit à une impulsion $Pr(r_k|r_{k-1})=P_{k-1,k}$.

A cet effet, on suppose que nous pouvons faire une hypothèse sur la durée des différents modes d'impulsion.

En supposant en particulier qu'une impulsion correspondant au $k^{ième}$ mode dure $T_k$, et que le pas d'échantillonnage est $T_e$, la probabilité de rester dans un même mode peut être estimée par :

$$\Pr\left(r_k|r_{k-1}=r_k\right) = \exp(-\frac{T_e}{T_k}\log(2))$$

Ceci revient à dire qu'il existe une chance sur deux que ce mode dure $T_k$.

Une plus grande précision n'est pas apparue nécessaire.

Les autres probabilités de transition sont calculées à partir d'une estimation de l'activité de la source étudiée.

**Exemple détaillé d'un mode de réalisation de l'invention**

On présente maintenant un exemple détaillé d'un mode de réalisation de l'invention.

Forme temporelle

A titre préliminaire, on suppose que l'on considère deux formes temporelles possibles d'impulsion.

Elles sont représentées à titre illustratif par les impulsions types 200 et 201 sur la figure 9.

Chaque impulsion type est associée une exponentielle de constante de temps $\alpha_1$ et $\alpha_2$ respectivement, cette exponentielle permettant de modéliser leur forme.

Le mode « bruit » correspondant entre autre à un retour à l'équilibre d'une impulsion, est le même quelque soit le type d'impulsion.

Une constante $\alpha_0$ est associée à ce mode « bruit ».

Gamme énergétique

On suppose en outre, que l'on cherche des impulsions dans une gamme d'énergie [$F_1$, $F_{Nf}$], avec $N_f$ nombre de gammes énergétiques.

On a donc un mode « bruit », et $2N_f$ modes d'impulsion différents, soit $N_m = 2N_f + 1$ avec $N_m$ le nombre total de modes d'impulsion (les $2N_f$ modes proviennent du fait que l'on dispose de deux modèles de forme temporelle différents et $N_f$ gammes énergétiques).

On suppose encore que l'on choisit des gammes énergétiques de largeurs égales et régulièrement espacées, soit :

$$F(r_k) = \beta \ F_1 \text{ et } B(r_k) = F_1$$

où $\beta$ est une constante.

On peut maintenant écrire une représentation numérique $s_k$ du signal courant détecteur :

$$\mathbf{x}_k = \alpha(\mathbf{r}_k)\mathbf{x}_{k-1} + F(\mathbf{r}_k) + B(\mathbf{r}_k)\mathbf{w}_k$$

sachant que pour chaque mode d'impulsion défini par la valeur de $r_k$, on a choisi un couple constante de temps (pour la forme temporelle de l'impulsion)/gamme énergétique.

En l'occurrence,

- si $r_k = 0$, alors $\alpha(r_k) = \alpha_0, F(r_k) = 0$ et $B(r_k) = le - 6$ (mode "bruit")
- si $r_k = 1$, alors $\alpha(r_k) = \alpha_1, F(r_k) = F_1$ et $B(r_k) = F_1$
- si $r_k = 2$, alors $\alpha(r_k) = \alpha_2, F(r_k) = F_1$ et $B(r_k) = F_1$
- si $r_k = 3$, alors $\alpha(r_k) = \alpha_1$, $F(r_k) = F_2 = 2F_1$ et $B(r_k) = F_1$
- si $r_k = 4$, alors $\alpha(r_k) = \alpha_2$, $F(r_k) = F_2 = 2F_1$ et $B(r_k) = F_1$
- si $r_k = N_m - 1$, alors $\alpha(r_k) = \alpha_1, F(r_k) = N_f F_1$ et $B(r_k) = F_1$
- si $r_k = N_m$, alors $\alpha(r_k) = \alpha_2, F(r_k) = N_f F_1$ et $B(r_k) = F_1$

En reprenant les notations des sections précédentes, le modèle d'état s'écrit finalement :

$$
X_k = \begin{pmatrix} x_k \\ b_k \\ n_k \end{pmatrix} = \overbrace{\begin{pmatrix} \alpha(r_k) & 0 & 0 \\ 0 & 1 & 0 \\ 0 & 0 & a_1 \end{pmatrix}}^{A(r_k)} \overbrace{\begin{pmatrix} x_{k-1} \\ b_{k-1} \\ n_{k-1} \end{pmatrix}}^{X_{k-1}} + \overbrace{\begin{pmatrix} F(r_k) \\ 0 \\ 0 \end{pmatrix}}^{G(r_k)} + \begin{pmatrix} B(r_k)w_k \\ \sigma_b u_k \\ \varepsilon_k \end{pmatrix}
$$

$$
y_k = \underbrace{\begin{bmatrix} 1 & 1 & 1 \end{bmatrix}}_{C} X_k
$$

Comme proposé précédemment, le bruit $n_k$ est modélisé par un modèle AR(1).

Pour obtenir une estimée sur $X_k$ d'ordre 2 qui est utile pour l'étape d'estimation de la chaîne de Markov, on augmente le système d'état.

A cet effet, le modèle d'état défini précédemment est transformé de la manière suivante :

$$
\begin{cases} \xi_{k+1} &= A^*(r_k^{(l)})\xi_k &+ G^*(r_{k+1}^{(l)}) &+ B^*(r_{k+1}^{(l)})v_{k+1} \\ y_k &= C^*\xi_k \end{cases}
$$

où,

$$
\xi_k = \begin{pmatrix} X_k \\ X_{k-1} \end{pmatrix}
$$

$$A^*(r_k^{(l)}) = \begin{pmatrix} A(r_k^{(l)}) & 0_{n_x \times n_x} \\ \mathrm{Id}_{n_x \times n_x} & 0_{n_x \times n_x} \end{pmatrix}$$

$$G^*(r_k^{(l)}) = \begin{pmatrix} G(r_k^{(l)}) \\ 0_{n_x \times 1} \end{pmatrix}$$

$$B^*(r_k^{(l)}) = \begin{pmatrix} B(r_k^{(l)}) & 0_{n_x \times n_x} \\ 0_{n_x \times n_x} & 0_{n_x \times n_x} \end{pmatrix}$$

$$v_k^* = \begin{pmatrix} v_k \\ v_{k-1} \end{pmatrix}$$

$$C^* = \begin{pmatrix} C & 0_{1 \times n_x} \end{pmatrix}$$

sachant que $n_x$ est la dimension du vecteur d'état considéré, $0_{m \times n}$ et $\mathrm{Id}_{m \times n}$ sont des matrices nulles et identité de taille $m \times n$, respectivement. Finalement nous appliquons les deux étapes suivantes :

Afin d'estimer les variables d'état, dont la variable X, on met en oeuvre le procédé décrit à la figure 9, le critère MAP-EM étant appliqué à la chaîne R dans cet exemple.

L'homme du métier adaptera sans difficulté le procédé aux deux autres cas pour lesquels le critère est appliqué à X ou (X, R).

Filtre de Kalman : étape 101

Un algorithme classique de filtre de Kalman est utilisé.
Par exemple, le filtrage comporte les étapes suivantes effectuées dans une boucle d'indice k, k variant de 1 à *N* :

$$\xi_{k|k-1} = A^*(r_k^{(l)})\xi_{k-1|k-1} + G^*(r_k^{(l)})$$

$$P_{k|k-1} = A^*(r_k^{(l)})P_{k-1|k-1}A^T(r_k^{(l)}) + B^*(r_k^{(l)})B^T(r_k^{(l)})$$

$$\varepsilon_k = y_k - C^*\xi_{k|k-1}$$

$$S_k = C^*P_{k|k-1}C^{*T}$$

$$K_k = P_{k|k-1}C^{*T}S_k^{-1}$$

$$\xi_{k|k} = \xi_{k|k-1} + K_k\varepsilon_k$$

$$P_{k|k} = P_{k|k-1} - P_{k|k-1}C^{*T} \times S_k^{-1}C^*P_{k|k-1}$$

où $\varepsilon_k$ est une innovation, $S_k$ est une variance de l'innovation $\varepsilon_k$, $K_k$ un gain de Kalman, $P_{k/k}$ une matrice de covariance de l'erreur d'estimation, $P_{k/k-1}$ une matrice de covariance de l'erreur de prédiction.

On observera que dans cet exemple la chaîne de Markov ne porte que sur les deux premières équations.

Lissage : étape 101

On utilise également un algorithme classique.

Il comporte par exemple les étapes suivantes effectuées dans une boucle d'indice k, k variant de *N-1* à 1 :

$$A_k = A\!\left(r_k^{(l)}\right) - K_k C^*$$

$$\lambda_{k/N} = A_k^*\!\left(r_k^{(l)}\right)\lambda_{k+1/N} + C^* S_k^{-1}\varepsilon_k \quad \text{avec } \lambda_{N/N} = 0_{n_x \times 1}$$

$$\Lambda_{k/N} = A_k^*\!\left(r_k^{(l)}\right)\Lambda_{k+1/N} A_k\!\left(r_k^{(l)}\right) + C^{*T} S_k^{-1} C \quad \text{avec } \Lambda_{N/N} = 0_{n_x \times n_x}$$

$$X_{k/N} = X_{k/k-1} + P_{k/k-1}\lambda_{k/N}$$

$$P_{k/N} = P_{k/k-1} - P_{k/k-1}\Lambda_{k/N} P_{k/k-1}$$

On obtient donc une estimation du vecteur d'état $X_k$ et ainsi du signal d'estimation non bruité $s_k$.

L'étape suivante 102 consiste alors à estimer la chaîne de Markov R. On utilise dans cet exemple un algorithme de Viterbi.

Celui-ci utilise la log-vraisemblance que l'on note ici $b_{r_k}(y_k, R^{(l)})$.

Cette grandeur est liée à la probabilité de se trouver dans le mode $r_k$ étant donné l'observation $y_k$.

Elle s'exprime dans cet exemple de la façon suivante :

$$
b_{r_k}(y_k, R^{(l)}) = -\frac{1}{2}\left[\frac{1}{D^2}\left(y_k\left(y_k - 2C\overline{X_k}^{(l)}\right) + \text{Trace}\left[C\overline{X_k X_k^T}^{(l)} C^T\right]\right)\right] - \frac{1}{2}\log\left(\left|B(r_k)B(r_k)^T\right|\right)
$$
$$
-\frac{1}{2}\text{Trace}\left\{\left[B(r_k)B(r_k)^T\right]^{-1} \times \left[\overline{X_k X_k^T}^{(l)} \times \overline{X_k X_{k-1}^T}^{(l)} A^T(r_k) - A(r_k)\overline{X_{k-1}X_k^T}^{(l)} + A(r_k)\overline{X_{k-1}X_{k-1}^T}^{(l)} A(r_k)^T\right.\right.
$$
$$
\left.\left. - G(r_k)\left(\overline{X_k}^{(l)} - A\overline{X_{k-1}}^{(l)}\right)^T - \left(\overline{X_k}^{(l)} - A\overline{X_{k-1}}^{(l)}\right)^T G(r_k)^T + G(r_k)G(r_k)^T\right]\right\}
$$

Les grandeurs incluant le vecteur d'état $X_k$ sont déterminées grâce au lisseur de Kalman précédemment décrit.

La structure de l'algorithme de Viterbi utilisé est la même que celle traditionnellement décrite dans la littérature.

Mais l'homme du métier observera que l'expression de la log-vraisemblance est ici particulière.

L'invention n'est nullement limitée à la forme de réalisation présentée dans cette description et les dessins annexés.

En particulier, on peut transformer le procédé de l'invention de façon simple en appliquant le critère MAP non pas sur la chaîne de Markov R comme cela a été décrit, mais sur le vecteur d'état $X_k$ ou sur $X_k$ et R conjointement.

A cet égard, si le critère d'optimalité MAP est appliqué sur X, on pourra procéder aux adaptations suivantes en se référant conjointement à la figure 8 :

- étape 100 d'initialisation de $\mathbf{X}^{(0)}$ ;
- calcul de probabilités conditionnelles en utilisant un estimateur de la chaîne de Markov ;
- calcul de $\mathbf{X}^{(\ell+1)}$ par un lisseur de Kalman, utilisant les probabilités précédemment estimées ;
- arrêt lorsque la distance euclidienne entre $\mathbf{X}^{(\ell)}$ et $\mathbf{X}^{(\ell+1)}$ est suffisamment faible.

Et si le critère d'optimalité MAP est appliqué sur X et sur R conjointement :

- phase d'initialisation de $X^{(0)}$ et de $R^{(0)}$ ;
- calcul de $X^{(\ell+1)}$ par un lisseur de Kalman (de même structure que dans l'algorithme décrit dans ce document) ;
- calcul de $R^{(\ell+1)}$ par un algorithme de Viterbi ;
- arrêt lorsque $R^{(\ell)} = R^{(\ell+1)}$.

Remarquons que ce dernier algorithme est de structure similaire à celui présenté à la figure 8.
Il diffère cependant notamment dans la phase d'estimation de la chaîne, où la log-vraisemblance est calculée différemment.

## REFERENCES BIBLIOGRAPHIQUES

[1] US5005146 04/91 Signal processing method for nuclear spectrometers.

[2] US5067090 11/91 Nuclear spectroscopy method and apparatus for digital pulse height analysis.

[3] US5684850 11/97 Method and apparatus for digitally based high.

[4] US5774522 06/98 Method and apparatus for digitally based high speed x-ray spectrometer for direct coupled use with continuous discharge preamplifiers.

[5] US5821533 10/98 Automatic pulse top optimisation circuit for an ionising radiation spectroscopy system.

[6] US5872363 02/99 Automatic pole-zero adjustment circuit for an ionising radiation spectroscopy system.

[7] US5873054 02/99 Method and apparatus for combinatorial logic signal processor in a digitally based high speed x-ray spectrometer.

[8] US5870051 02/99 Method and apparatus for analog signal conditioner for high speed, digital x-ray spectrometer.

[9] US6295508 09/01 Automatic pole-zero adjustment circuit for an ionising radiation spectroscopy system and method.

[10] US6347288 02/02 Automatic pole-zero adjustment circuit for an ionising radiation spectroscopy system and method.

[11] US6374192 04/02 Apparatus and method for automatic correction of pole-zero error in a spectroscopy system.

[12] US6522984 02/03 Instant pole-zero corrector for digital radiation spectrometers and the same with automatic attenuator calibration

[13] US5912825 06/99 Gated base line restorer

[14] US5884234 03/99 Method for pulse shape regulation and discrimination in a nuclear spectroscopy system.

**Revendications**

1.  Procédé de traitement d'un signal temporel numérique bruité $y_k$ de pas numérique k, correspondant à un signal initial analogique $s_t$ après avoir été conditionné par une chaîne de conditionnement, ledit signal initial analogique $s_t$ comportant au moins une impulsion représentative d'une information sur au moins un rayonnement (30) provenant d'une source de rayonnements, ce rayonnement (30) et cette impulsion présentant une distribution en énergie, le procédé déterminant à partir du signal temporel bruité $y_k$ un signal d'estimation numérique non bruité $s_k$ au moyen d'un modèle d'état représentatif dudit conditionnement imposé par la chaîne de conditionnement **caractérisé en ce que** le modèle d'état comporte une variable markovienne $r_k$ à estimer dont au moins deux valeurs sont associées à des caractéristiques physiques d'au moins deux impulsions type, ces impulsions type constituant une représentation possible, tout au moins approchée, des impulsions dans le signal $s_t$.

**2.** Procédé de traitement selon la revendication 1, **caractérisé en ce qu'**il comporte en outre une étape préalable où l'on segmente le signal temporel numérique bruité $y_k$ en tronçons successifs de N échantillons.

**3.** Procédé de traitement selon l'une des revendications précédentes, **caractérisé en ce que** l'une des valeurs de la variable markovienne correspond à un mode d'impulsion, dit mode « bruit », pour lequel on considère qu'il n'existe pas d'impulsion dans le signal à un pas k donné.

**4.** Procédé de traitement selon la revendication précédente, **caractérisé en ce que** le modèle d'état comporte en outre un vecteur F de constantes dépendantes de la variable markovienne et qui définissent en tant que caractéristiques physiques une gamme énergétique liée à l'impulsion type en question.

**5.** Procédé de traitement selon la revendication précédente, **caractérisé en ce que** les constantes du vecteur F sont proportionnelles à une amplitude maximale prédéterminée $A_{min}$ d'une impulsion type liée à la gamme énergétique la plus faible, le mode « bruit » n'étant pas considéré ici.

**6.** Procédé de traitement selon l'une des revendications précédentes, **caractérisé en ce que** le modèle d'état comporte un vecteur d'état $X_k$ à estimer, lequel comporte une première composante qui correspond à l'estimation numérique non bruitée $s_k$, c'est à dire à la représentation numérisée du signal initial temporel $s_t$ à l'instant t correspondant au pas k en question, et **en ce que** la détermination à partir du signal temporel bruité $y_k$ du signal d'estimation numérique non bruité $s_k$ au moyen du modèle d'état comporte une étape intermédiaire de mise en oeuvre d'un filtre de Kalman d'observation le signal temporel numérique bruité $y_k$, cette étape intermédiaire fournissant une estimation intermédiaire $X_{k/k}$ du vecteur d'état $X_k$ comportant ainsi un signal d'estimation numérique intermédiaire $s_{k/k}$ non bruité, celui-ci correspondant à une première détermination du signal d'estimation numérique non bruité $s_k$ que l'on cherche à obtenir.

**7.** Procédé de traitement selon la revendication précédente, **caractérisé en ce que** la détermination à partir du signal temporel bruité $y_k$ du signal d'estimation numérique non bruité $s_k$ au moyen du modèle d'état comporte une seconde étape intermédiaire de mise en oeuvre d'un algorithme de lissage, cette étape intermédiaire fournissant une estimation lissée $X_{k/N}$ améliorée du vecteur d'état $X_k$, et donc une estimation lissée $s_{k/N}$ améliorée du signal d'estimation numérique non bruité $s_k$ que l'on cherche à obtenir.

**8.** Procédé de traitement selon l'une des revendications précédentes, **caractérisé en ce que** la variable cachée $r_k$ est estimée au moyen d'un algorithme de Viterbi.

**9.** Procédé de traitement selon l'une des revendications précédentes, **caractérisé en ce que** l'on utilise un critère d'optimisation du Maximum A Posteriori (MAP).

**10.** Procédé de traitement selon la revendication précédente, **caractérisé en ce que** le critère du Maximum A Posteriori (MAP) est combiné à un algorithme Expectation-Maximization (EM).

**11.** Procédé de traitement selon la revendication précédente, **caractérisé en ce que** le critère du Maximum A Posteriori combiné à l'algorithme Expectation-Maximization (EM) est mis en oeuvre au choix :

- pour l'estimation de la variable cachée rk,
- pour l'estimation du vecteur d'état $X_k$, ou
- pour l'estimation de la variable cachée $r_k$ et du vecteur d'état $X_k$.

**12.** Procédé de traitement selon l'une des revendications précédentes, **caractérisé en ce que** le modèle d'état s'exprime sous la forme suivante :

$$\begin{cases} X_{k+1} & = & A(r_{k+1})X_k & + & G(r_{k+1}) & + & B(r_{k+1})v_{k+1} \\ y_k & = & CX_k \end{cases}$$

avec :

$$X_k = \begin{pmatrix} s_k \\ b_k \\ n_k \end{pmatrix},$$

où A est une matrice d'état, C une matrice d'observation, $v_k$ un vecteur de bruit blanc gaussien de variance unité, G un vecteur comportant le vecteur F de constantes, B une matrice de bruit dynamique, $b_k$ un biais, et $n_k$ un bruit intrinsèque à un détecteur des rayonnements utilisé dans la chaîne de conditionnement.

13. Procédé de traitement selon la revendication précédente, **caractérisé en ce qu'**il comporte une étape d'initialisation dans laquelle la matrice de bruit dynamique B associée au canal énergétique le plus faible est égale à celle associée au canal énergétique juste supérieur, soit

$$B(r_k=0) = B(r_k=1)$$

et dans laquelle, pour les valeurs de $r_k$ supérieures ou égales à 1, la matrice $B(r_k)$ est déterminée par

$$B(r_k) = F(r_k) - F(r_{k-1}), \ r_k \geq 1$$

14. Programme d'ordinateur pour le traitement d'un signal temporel numérique bruité $y_k$ de pas numérique k, correspondant à un signal initial analogique $s_t$ après avoir été conditionné par une chaîne de conditionnement, ledit signal initial analogique $s_t$ comportant au moins une impulsion représentative d'une information sur au moins un rayonnement (30) provenant d'une source de rayonnements, ce rayonnement (30) et cette impulsion présentant une distribution en énergie, **caractérisé en ce qu'**il comporte des instructions pour la mise en oeuvre du procédé selon l'une quelconque des revendications précédentes.

15. Système de traitement d'un signal temporel numérique bruité yk de pas k correspondant à un signal initial analogique st après avoir été conditionné par une chaîne de conditionnement, ledit signal analogique st comportant au moins une impulsion représentative d'une information sur des rayonnements provenant d'une source de rayonnements, ces rayonnements et cette impulsion présentant une distribution en énergie, caractérisé en qu'il comporte des moyens coopérant avec un modèle d'état représentatif dudit conditionnement imposé par la chaîne de conditionnement pour déterminer à partir du signal temporel bruité yk un signal d'estimation numérique non bruité sk et en ce que le modèle d'état comporte une variable markovienne rk à estimer dont au moins deux valeurs permettent de définir des caractéristiques physiques d'au moins deux impulsions type, ces impulsions type constituant une représentation possible, tout au moins approchée, de l'impulsion dans le signal st.

16. Spectromètre comportant des moyens aptes à mettre à oeuvre un procédé selon l'une quelconque des revendications 1 à 13.

17. Bolomètre comportant des moyens aptes à mettre en oeuvre un procédé selon l'une quelconque des revendications 1 à 13.

**Patentansprüche**

1. Verarbeitungsverfahren eines zeitlichen, digitalen Rauschsignals $y_k$ des digitalen Schrittes k, das einem ursprünglichen analogen Signal $S_t$ entspricht, nachdem es von einer Konditionierungskette konditioniert wurde, wobei das genannte ursprüngliche analoge Signal $S_t$ wenigstens einen Impuls umfasst, der eine Information auf wenigstens einer Strahlung (30) darstellt, die aus einer Strahlungsquelle stammt, wobei diese Strahlung (30) und dieser Impuls eine Energieverteilung aufweisen, wobei das Verfahren ausgehend von dem zeitlichen Rauschsignal $y_k$ ein digitales, nicht rauschendes Schätzungssignal $s_k$ mittels eines Zustandsmodells bestimmt, das die genannte Konditionierung darstellt, die von der Konditionierungskette vorgeschrieben wird, **dadurch gekennzeichnet, dass** das Zustandsmodell eine zu schätzende Markov-Variable $r_k$ umfasst, von der wenigstens zwei Werte physischen Merkmalen von wenigstens zwei typischen Impulsen zugeordnet sind, wobei diese typischen Impulse eine mögliche, zumindest ange-näherte Darstellung der Impulse in dem Signal $S_t$ bilden.

2. Verarbeitungsverfahren gemäß Anspruch 1, **dadurch gekennzeichnet, dass** es darüber hinaus einen vorherigen Schritt umfasst, in dem das zeitliche digitale Rauschsignal $y_k$ in sukzessive Abschnitte von N Proben segmentiert wird.

3. Verarbeitungssignal gemäß irgendeinem der voranstehenden Ansprüche, **dadurch gekennzeichnet, dass** einer der Werte der Markov-Variablen einem Impulsmodus, bezeichnet als "Geräusch"-Modus, entspricht, für den davon ausgegangen wird, dass in dem Signal mit einem bestimmten Schritt k kein Impuls existiert.

4. Verarbeitungsverfahren gemäß dem voranstehenden Anspruch, **dadurch gekennzeichnet, dass** das Zustandsmodell darüber hinaus einen Vektor F von unabhängigen Konstanten der Markov-Variablen umfasst und die als physische Merkmale ein energetisches Spektrum definieren, das mit dem in Frage stehenden typischen Impuls verbunden ist.

5. Verarbeitungsverfahren gemäß dem voranstehenden Anspruch, **dadurch gekennzeichnet, dass** die Konstanten des Vektors F proportional zu einer vorbestimmten maximalen Amplitude $A_{min}$ eines typischen Impulses sind, der mit dem geringsten energetischen Spektrum verbunden ist, wobei der "Geräusch"-Modus hier nicht betrachtet wird.

6. Verarbeitungsverfahren gemäß irgendeinem der voranstehenden Ansprüche, **dadurch gekennzeichnet, dass** das Zustandsmodell einen zu schätzenden Zustandsvektor $X_k$ umfasst, welcher eine erste Komponente umfasst, die der digitalen, nicht rauschenden Schätzung $S_k$ entspricht, d. h. der digitalisierten Darstellung des ursprünglichen zeitlichen Signals $S_t$ zu dem Zeitpunkt t, der dem in Frage stehenden Schritt k entspricht, und dass die Bestimmung ausgehend von dem zeitlichen Rauschsignal $y_k$ des nicht rauschenden, digitalen Schätzungssignals $S_k$ mittels des Zustandsmodells einen Zwischenschritt der Umsetzung eines Kalmanfilters zur Beobachtung des digitalen, zeitlichen Rauschsignals $y_K$ umfasst, wobei dieser Zwischenschritt eine Zwischenschätzung $X_{k/k}$ des Zustandsvektors $X_k$ liefert, der somit ein digitales, intermediäres, nicht rauschendes Schät-zungssignal $S_{k/k}$ umfasst, wobei dieses einer ersten Bestimmung des digitalen, nicht rauschenden Schätzungssignals $S_k$ entspricht, das erhalten werden soll.

7. Verarbeitungsverfahren gemäß dem voranstehenden Anspruch, **dadurch gekennzeichnet, dass** die Bestimmung ausgehend von dem zeitlichen Rauschsignal $y_k$ des digitalen, nicht rauschenden Schätzungssignals $S_k$ mittels des Zustandsmodells einen zweiten Zwischenschritt der Umsetzung eines Glättungsalgorithmus umfasst, wobei dieser Zwischenschritt eine verbesserte, geglättete Schätzung $X_{k/n}$ des Zustandsvektors $X_k$ und damit eine verbesserte, geglättete Schätzung $S_{k/N}$ des digitalen, nicht rauschenden Schätzungssignals $S_k$ liefert, das erhalten werden soll.

8. Verarbeitungsverfahren gemäß einem der voranstehenden Ansprüche, **dadurch gekennzeichnet, dass** die verborgene Variable $r_K$ mittels eines Viterbi-Algorithmus geschätzt wird.

9. Verarbeitungsverfahren gemäß irgendeinem der voranstehenden Ansprüche, **dadurch gekennzeichnet, dass** ein Optimierungskriterium des Maximums A Posteriori (MAP) verwendet wird.

10. Verarbeitungsverfahren gemäß dem voranstehenden Anspruch, **dadurch gekennzeichnet, dass** das Kriterium des Maximums A Posteriori (MAP) mit einem Algorithmus Expectation-Maximization (EM) kombiniert wird.

11. Verarbeitungsverfahren gemäß dem voranstehenden Anspruch, **dadurch gekennzeichnet, dass** das Kriterium des Maximums A Posteriori, das mit dem Algorithmus Expectation-Maximization (EM) kombiniert wird, wahlweise umgesetzt wird:

   - zur Schätzung der verborgenen Variablen $r_k$,
   - zur Schätzung des Zustandsvektors $X_k$ oder
   - zur Schätzung der verborgenen Variablen $r_k$ und des Zustandsvektors $X_k$.

12. Verarbeitungsverfahren gemäß einem der voranstehenden Ansprüche, **dadurch gekennzeichnet, dass** das Zustandsmodell in der folgenden Form ausgedrückt wird:

$$\begin{cases} X_{k+1} & = & A(r_{k+1})X_k & + & G(r_{k+1}) & + & B(r_{k+1})v_{k+1} \\ y_k & = & CX_k \end{cases}$$

mit

$$X_k = \begin{pmatrix} s_k \\ b_k \\ n_k \end{pmatrix},$$

wobei A eine Zustandsmatrix ist, C eine Beobachtungsmatrix, $v_K$ ein Vektor eines Gaußschen weißen Rauschens einer Einheitsvariante, G ein Vektor ist, der den Konstantenvektor F umfasst, B eine Matrix eines dynamischen Geräuschs, $b_k$ eine Verzerrung und $n_k$ ein intrinsisches Geräusch eines Detektors der Strahlungen, der in der Konditionierungskette verwendet wird.

13. Verarbeitungsverfahren gemäß dem voranstehenden Anspruch, **dadurch gekennzeichnet, dass** es einen Initialisierungsschritt umfasst, in dem die dynamische Geräuschmatrix B, die dem schwächsten Energiekanal zugeordnet ist, gleich der ist, die dem direkt übergeordneten Energiekanal zugeordnet ist, d. h.

$$B(r_k=0) = B(r_k=1)$$

und in dem für die Werte von $r_K$ größer als oder gleich 1 die Matrix B ($r_K$) bestimmt wird durch

$$B(r_k) = F(r_k) - F(r_{k-1}), \ r_k \geq 1$$

14. Computerprogramm für die Verarbeitung eines zeitlichen, digitalen Rauschsignals $y_k$ des digitalen Schritts k, das einem ursprünglichen analogen Signal $S_t$ entspricht, nachdem es von einer Konditionierungskette konditioniert wurde, wobei das genannte ursprüngliche analoge Signal $S_t$ wenigstens einen Impuls umfasst, der eine Information auf wenigstens einer Strahlung (30) darstellt, die aus einer Strahlungsquelle stammt, wobei diese Strahlung (30) und dieser Impuls eine Energieverteilung darstellen, **dadurch gekennzeichnet, dass** sie Anweisungen für die Umsetzung des Verfahrens gemäß irgendeinem der voranstehenden Ansprüche umfasst.

15. Verarbeitungssystem eines zeitlichen, digita-len Rauschsignals yk des Schritts k, das einem ursprünglichen analogen Signal st entspricht, nachdem es von einer Konditionierungskette konditioniert wurde, wobei das genannte analoge Signal st wenigstens einen Impuls umfasst, der eine Information auf Strahlungen darstellt, die aus einer Strahlungsquelle stammen, wobei diese Strahlungen und dieser Impuls eine Energieverteilung darstellen, **dadurch gekennzeichnet, dass** es Mittel umfasst, die mit einem Zustandsmodell zusammenwirken, das die genannte Konditionierung darstellt, die von der Konditionierungskette vorgeschrieben wird, um ausgehend von dem zeitlichen Rauschsignal yk ein digitales, nicht rauschendes Schätzungssignal sk zu bestimmen und dass das Zustandsmodell eine zu schätzende Markov-Variable rk umfasst, von der wenigstens zwei Werte die Definition der physischen Merkmale wenigstens zweier typischer Impulse zulassen, wobei diese typischen Impulse eine mögliche, zumindest angenäherte Darstellung des Impulses in dem Signal st bilden.

16. Spektrometer, umfassend Mittel, die geeignet sind, ein Verfahren gemäß irgendeinem der Ansprüche 1 bis 13 umzusetzen.

17. Bolometer, umfassend Mittel, die geeignet sind, ein Protokoll gemäß irgendeinem der Ansprüche 1 bis 13 umzusetzen.

**Claims**

1. Method for processing a noisy digital time signal $y_k$ of digital pitch k, corresponding to an initial analogue signal $S_t$ after being conditioned by a conditioning chain, said initial analogue signal $s_t$ comprising at least one pulse representing information concerning at least one radiation (30) from a source of radiation, with this radiation (30) and this pulse having an energy distribution, with the method determining from said noisy time signal $y_k$ a non-noisy digital estimation signal $s_k$ by means of a state model representing said conditioning imposed by the conditioning chain **characterised in that** the state model includes a Markovian variable $r_k$, to be estimated whereof at least two values are associated with physical characteristics of at least two typical pulses, with these typical pulses constituting a possible representation, at least approximate, of the pulse in the signal $s_t$.

2. Method for processing according to claim 1, **characterised in that** it further comprises a prior step wherein the noisy digital time signal $y_k$ is segmented into successive sections of N samples.

3. Method for processing according to one of the preceding claims, **characterised in that** one of the values of the Markovian variable corresponds to a pulse mode, referred to as a "noisy" mode, for which it is considered that there is no pulse in the signal at a given pitch k.

4. Method for processing as claimed in the preceding claim, **characterised in that** the state model further comprises a vector F of constants that depend on the Markovian variable and which define as physical characteristics an energy range linked to the typical pulse in question.

5. Method for processing as claimed in the preceding claim, **characterised in that** the constants of the vector F are proportional to a predetermined maximum amplitude $A_{min}$ of a typical pulse linked to the lowest energy range, with the "noisy" mode not considered here.

6. Method for processing according to one of the preceding claims, **characterised in that** the state model comprises a state vector $X_k$, to be estimated, which comprises a first component which corresponds to the non-noisy digital estimation $s_k$, i.e. the digitised representation of the initial time signal $s_t$ at instant t corresponding to the pitch k in question, and **in that** the determination from said noisy time signal $y_k$ of the non-noisy digital estimation signal $s_k$ by means of the state model comprises an intermediate step of implementing a Kalman filter for observing the noisy digital time signal $y_k$, with this intermediate step supplying an intermediate estimation $X_{k/k}$ of the state vector $X_k$ comprising as such a non-noisy intermediate digital estimation signal $s_{k/k}$, with the latter corresponding to a first determination of the non-noisy digital estimation signal $s_k$ that is sought to be obtained.

7. Method for processing as claimed in the preceding claim, **characterised in that** the determination from said noisy time signal $y_k$ of the non-noisy digital estimation signal $s_k$ by means of the state model comprises a second intermediate step of implementing a smoothing algorithm, with this intermediate step supplying an improved smoothes estimation $X_{k/N}$ of the state vector $X_k$, and therefore an improved smoothed estimation $S_{k/N}$ of the non-noisy digital estimation signal $s_k$ that is sought to be obtained.

8. Method for processing according to one of the preceding claims, **characterised in that** the hidden variable $r_k$, is estimated by means of a Viterbi algorithm.

9. Method for processing according to one of the preceding claims, **characterised in that** an optimisation criterion of the Maximum A Posteriori (MAP) is used.

10. Method for processing as claimed in the preceding claim, **characterised in that** the criterion of the Maximum A Posteriori (MAP) is combined with an Expectation-Maximization (EM) algorithm.

11. Method for processing as claimed in the preceding claim, **characterised in that** the criterion of the Maximum A Posteriori combined with the Expectation-Maximization (EM) algorithm is implemented by choice:

    - for estimating the hidden variable $r_k$,
    - for estimating the state vector $X_k$, or
    - for estimating the hidden variable $r_k$ and the state vector $X_k$.

12. Method for processing according to one of the preceding claims, **characterised in that** the state model is expressed in the following form:

$$\begin{cases} X_{k+1} & = & A(r_{k+1})X_k & + & G(r_{k+1}) & + & B(r_{k+1})v_{k+1} \\ y_k & = & CX_k \end{cases}$$

with:

$$X_k = \begin{pmatrix} s_k \\ b_k \\ n_k \end{pmatrix},$$

where A is a state matrix, C an observation matrix, $V_k$ a vector of white Gaussian noise of unit variance, G a vector containing the vector F of constants, B a dynamic noise matrix, $b_k$ a bias, and $n_k$ a noise intrinsic to a radiation detector used in the conditioning chain.

13. Method for processing as claimed in the preceding claim, **characterised in that** it comprises a step of initialising in which the dynamic noise matrix B associated with the lowest energy channel is equal to that associated with the immediately superior energy channel, i.e.

$$B(r_k=0) = B(r_k=1)$$

and in which, for the values of $r_k$ greater than or equal to 1, the matrix $B(r_k)$ is determined by

$$B(r_k) = F(r_k) - F(r_{k-1}), \quad r_k \geq 1$$

14. Computer program for the processing of a noisy digital time signal $y_k$ of digital pitch k, corresponding to an initial analogue signal St after being conditioned by a conditioning chain, said initial analogue signal $s_t$ comprising at least one pulse representing information concerning at least one radiation (30) from a radiation source, said radiation (30) and said pulse having an energy distribution, **characterised in that** it comprises instructions for the implementing of the method as claimed in any preceding claim.

15. System for processing a noisy digital time signal yk of pitch k corresponding to an initial analogue signal st after being conditioned by a conditioning chain, said analogue signal st comprising at least one pulse representative of information on radiation coming from a radiation source, with this radiation and this pulse having an energy distribution, **characterised in that** it comprises means that cooperate with a state model representative of said conditioning imposed by the conditioning chain in order to determine from said noisy time signal yk a non-noisy digital estimation signal sk and **in that** the state model includes a Markovian variable rk to be estimated of which at least two values make it possible to define physical characteristics of at least two typical pulses, with these typical pulses constituting a possible representation, at least approximate, of the pulse in the signal st.

16. Spectrometer comprising means able to implement a method according to any of claims 1 to 13.

17. Bolometer comprising means able to implement a method according to any of claims 1 to 13.

## FIG. 1 - ART ANTERIEUR

## FIG. 2 - ART ANTERIEUR

**FIG. 3 - ART ANTERIEUR**

**FIG. 4 - ART ANTERIEUR**

## FIG. 5 - ART ANTERIEUR

## FIG. 6 - ART ANTERIEUR

# FIG. 7

## FIG. 8

100 —

| Tronçon de signal de $N$ échantillons sans impulsion, $R^{(0)} = 0$ |

101 —

| Estimation de $X^{(l)}$ par lisseur de Kalman, sous l'hypothèse $R^{(l)}$ |

$l = l + 1$

| Estimation de la chaîne $R^{(l+1)}$ en fonction du lissage précédent, par un algorithme de Viterbi |

102 —

| $R^{(l+1)} = R^{(l)}$ |

103 —

| NON |   | OUI |

Nouveau tronçon

## FIG. 9

Signal et chaîne de Markov (unités arbitraires)

200

$\alpha(r_k) = \alpha_1$

201

$\alpha(r_k) = \alpha_2$

$\alpha(r_k) = \alpha_0$

t (s)

x 10⁻⁴

**EP 1 904 872 B1**

**RÉFÉRENCES CITÉES DANS LA DESCRIPTION**

**Documents brevets cités dans la description**

- US 2005129152 A1
- US 5005146 A
- US 5067090 A
- US 5684850 A
- US 5774522 A
- US 5821533 A
- US 5872363 A
- US 5873054 A
- US 5870051 A
- US 6295508 B
- US 6347288 B
- US 6374192 B
- US 6522984 B
- US 5912825 A
- US 5884234 A